# FASCICULE DE BREVET EUROPEEN

(11) **EP 2 592 429 B1**
(45) Date de publication et mention de la délivrance du brevet: **30.07.2014**
(21) Numéro de dépôt: 12192477.3
(22) Date de dépôt: 13.11.2012
(51) Int. Cl.: G01R 33/038, G01R 33/028

(54) **Capteur vectoriel de champ magnétique**
Vektorieller Magnetfeldsensor
Vector magnetic field sensor

(30) Priorité: 14.11.2011 FR 1160325
(43) Date de publication de la demande: 15.05.2013
(73) Titulaire: Commissariat à l'Énergie Atomique et aux Énergies Alternatives, 75015 Paris (FR); Institut Polytechnique de Grenoble, 38500 Grenoble (FR)
(72) Inventeur: Ettelt, Dirk, 45892 Gelsenkirchen (DE); Delamare, Jérome, 38000 Grenoble (FR); Lebedev, Gor, 38100 Grenoble (FR); Viala, Bernard, 38360 Sassenage (FR)
(74) Mandataire: Colombo, Michel

(56) Documents cités:
- US-A1- 2011 140 693
- DIRK ETTELT ET AL: "A novel microfabricated high precision vector magnetometer", 2011 IEEE SENSORS PROCEEDINGS : LIMERICK, IRELAND, 28 - 31 OCTOBER 2011, IEEE, PISCATAWAY, NJ, 28 octobre 2011 (2011-10-28), pages 2010-2013, XP032093132, DOI: 10.1109/ICSENS.2011.6126925 ISBN: 978-1-4244-9290-9

## Description

L'invention concerne un capteur vectoriel de champ magnétique ainsi qu'un procédé de mesure d'un champ magnétique à l'aide de ce capteur.

Un capteur vectoriel est un capteur qui permet de mesurer les composantes d'un champ magnétique à mesurer dans un repère à deux ou trois dimensions. Ici, dans un repère à deux dimensions, ces composantes sont notées c_{X} et c_{Y}. Dans un repère à trois dimensions, ces composantes sont notées c_{X}, c_{Y} et c_{Z}. Un capteur vectoriel permet donc de mesurer la direction et, de préférence aussi l'amplitude, du champ magnétique. Les composantes c_{X}, c_{Y} et c_{Z} correspondent à la projection orthogonale du champ magnétique à mesurer, respectivement, sur des axes X, Y et Z du repère.

Des capteurs vectoriels connus de champ magnétique comportent :
- un substrat fixe s'étendant essentiellement parallèlement à un plan dit « plan du substrat »,
- un support mobile par rapport au substrat apte à se déplacer en rotation autour d'au moins un axe vertical Z de rotation perpendiculaire au plan du substrat,
- une source de champ magnétique présentant un moment magnétique dans une direction non perpendiculaire au plan du substrat, cette source étant fixée sans aucun degré de liberté sur le support mobile de manière à exercer un couple mécanique sur le support autour de l'axe vertical de rotation en présence d'un champ magnétique à mesurer non colinéaire à la direction de ce moment magnétique,
- au moins un transducteur apte à convertir le couple exercé sur le support mobile autour de l'axe de rotation en un signal électrique représentatif de l'amplitude d'une composante du champ magnétique à mesurer le long d'un axe de mesure contenu dans le plan du substrat.

Lorsque la source de champ magnétique est plongée dans le champ magnétique à mesurer, un couple ┌ fonction du moment magnétique de la source, de l'amplitude du champ magnétique à mesurer et de l'angle entre le moment magnétique de la source et la direction du champ magnétique à mesurer apparaît. Ce couple ┌ tend à faire tourner le support mobile de manière à ce que la direction du moment magnétique de la source s'aligne sur la direction du champ magnétique à mesurer. Un couple s'exerce donc sur le support mobile. Ce couple ou une grandeur représentative de ce couple, tel qu'un déplacement angulaire, est mesuré par les transducteurs.

Toutefois, pour déterminer sans ambiguïté les composantes c_{X} et c_{Y} du champ magnétique à mesurer contenues dans le plan du substrat du capteur, il faut nécessairement au moins deux sources de champ magnétique dont les moments magnétiques sont alignés le long de deux directions différentes. Par conséquent, les capteurs connus comportent au moins un premier et un second support mobile portant respectivement chacun l'une de ces sources de champ magnétique.

La présence de plusieurs supports mobiles et de plusieurs sources de champ magnétique pose notamment les problèmes suivants :
- cela augmente l'encombrement du capteur,
- cela peut provoquer des erreurs de mesure d'un capteur à l'autre car il est difficile de positionner et d'orienter précisément exactement de la même façon les sources de champ magnétique les unes par rapport aux autres dans chaque capteur, et
- un couplage magnétique peut exister entre les différentes sources de champ magnétique, ce qui introduit un biais dans la mesure.

De l'état de la technique est également connu de US2011/0140693A1 et de l'article de Dirk Ettelt et al, «A novel Microfabricated High Precision Vector Magnetometer », 2011 IEEE Sensors Proceedings : Limerick, Ireland, 28-31 Octobre 2011, pages 2010-2013.

L'invention vise à remédier à au moins l'un de ces inconvénients. Elle a donc pour objet un capteur vectoriel de champ magnétique conforme à la revendication 1.

Le fait de pouvoir modifier la direction du moment magnétique de la source de champ magnétique permet de n'utiliser qu'une seule source de champ magnétique pour mesurer les composantes c_{X} et c_{Y}. L'encombrement de ce capteur est donc limité puisqu'un seul générateur de champ magnétique est utilisé pour mesurer les deux composantes c_{X} et c_{Y}. De plus, les problèmes de positionnement des différentes sources de champ magnétique les unes par rapport aux autres sont éliminés. Le risque de couplage magnétique entre ces différentes sources de champ magnétique est également éliminé puisqu'une seule source de champ magnétique est utilisée.

Les modes de réalisation de ce capteur peuvent comporter une ou plusieurs des caractéristiques des revendications dépendantes.

Ces modes de réalisation du capteur présentent en outre les avantages suivants :
- utiliser un aimant permanent, constitué d'un matériau monobloc ou d'un empilement de couches Antiferromagnétique/ferromagnétique dont l'aimantation rémanente globale est non nul, permet de décroître la consommation électrique du capteur,
- orienter la direction du moment magnétique de la source de champ magnétique parallèlement ou perpendiculairement à la direction d'étirement selon la valeur du coefficient λₛ de magnétostriction permet d'accroître la sensibilité du capteur,
- l'utilisation d'une poutre dont les extrémités au moins sont en matériau piézoélectrique permet d'appliquer simplement et de façon contrôlée une contrainte uniaxiale sur l'aimant permanent,
- utiliser en tant que source de champ magnétique des premier et second conducteurs électriques s'étendant dans des directions respectives permet de commander simplement l'intensité du moment magnétique généré par la source en plus de sa direction,
- l'utilisation d'un cadre relié au support par l'intermédiaire d'un jeu de poutres et relié au substrat par l'intermédiaire d'un autre jeu de poutres déformables en flexion et en torsion permet de réaliser simplement un capteur capable de mesurer les composantes c_{X}, c_{Y} et c_{Z},
- aligner, en alternance, le moment magnétique de la source sur les axes X et Y du repère permet de mesurer simplement les composantes c_{X} et c_{Y} du champ magnétique à mesurer.

L'invention a également pour objet un procédé de mesure d'un champ magnétique à l'aide du capteur ci-dessus conforme à la revendication 8.

L'invention sera mieux comprise à la lecture de la description qui va suivre, donnée uniquement à titre d'exemple non limitatif et faite en se référant aux dessins sur lesquels :
- la figure 1 est une illustration schématique en coupe verticale d'un capteur vectoriel,
- la figure 2 est une illustration schématique en vue de dessus du capteur de la figure 1,
- la figure 3 est une illustration schématique et en coupe verticale d'un premier mode de réalisation d'un générateur de contrainte utilisé dans le capteur de la figure 1,
- la figure 4 est une illustration schématique et en vue de dessus du générateur de contrainte de la figure 3,
- la figure 5 est un organigramme d'un procédé de fabrication du capteur de la figure 1,
- les figures 6 à 17 sont des illustrations schématiques en coupe verticale de différentes étapes de fabrication du capteur de la figure 1,
- la figure 18 est un organigramme d'un procédé de mesure de champ magnétique à l'aide du capteur de la figure 1,
- la figure 19 est une illustration schématique d'un deuxième mode de réalisation d'un générateur de contrainte susceptible d'être utilisé dans le capteur de la figure 1,
- la figure 20 est une illustration schématique et en vue d'un autre mode de réalisation d'une source de champ magnétique susceptible d'être mise en oeuvre dans le capteur de la figure 1,
- la figure 21 est une illustration schématique et en coupe verticale d'un troisième mode de réalisation d'un générateur de contrainte susceptible d'être utilisé dans le capteur de la figure 1, et
- la figure 22 est une illustration schématique d'un autre mode de réalisation d'une source de champ magnétique utilisable dans le capteur de la figure 1.

Dans ces figures, les mêmes références sont utilisées pour désigner les mêmes éléments.

Dans la suite de cette description, les caractéristiques et fonctions bien connues de l'homme du métier ne sont pas décrites en détail.

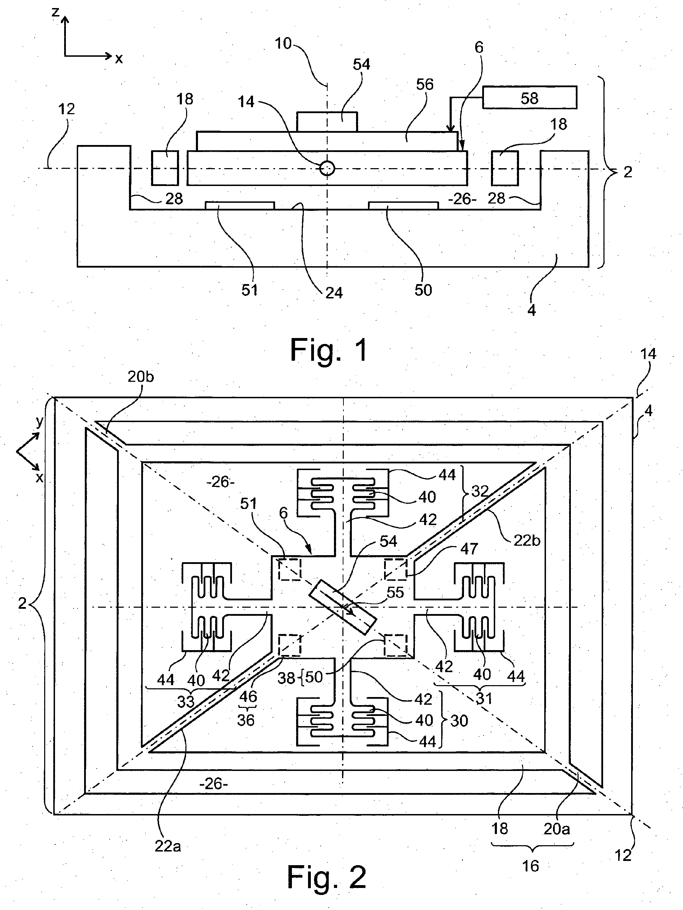

Les figures 1 et 2 représentent un capteur vectoriel 2 de champ magnétique. Ce capteur 2 est apte à mesurer la projection orthogonale du champ magnétique à mesurer sur trois axes orthogonaux 10, 12 et 14. Ici, ces axes sont parallèles, respectivement, aux directions X, Y et Z d'un repère orthogonal. Les directions X et Y sont des directions horizontales tandis que la direction Z est une direction verticale. Par la suite, les termes tels que « au-dessus », « au-dessous », « supérieur » et « inférieur » sont définis par rapport à la direction Z. Sur la figure 1, l'axe 14 est perpendiculaire au plan de la feuille. Pour limiter l'encombrement de la figure 2, celle-ci a été écrasée dans une direction de sorte que les axes 12 et 14 n'apparaissent pas comme étant perpendiculaires entre eux.

Le capteur 2 comporte un substrat rigide 4 s'étendant essentiellement dans un plan horizontal appelé « plan du substrat ». Typiquement, l'épaisseur dans la direction verticale de ce substrat 4 est supérieure à 10µm, 50µm ou 100 µm.

Le capteur 2 comporte aussi un support mobile 6 déplaçable en rotation autour des axes 10, 12 et 14. Ici, ce support a une section horizontale rectangulaire ou carrée. Le support 6 est raccordé mécaniquement au substrat 4 par l'intermédiaire d'un mécanisme articulé 16 (figure 2) permettant au support de se déplacer en rotation autour des axes 10, 12 et 14.

Ici, ce mécanisme 16 comporte :
- un cadre 18 rigide qui ne se déforme pas en réponse à la rotation du support 6,
- un jeu de deux poutres 20a et 20b aptes à maintenir le cadre 16 suspendu au-dessus du substrat 4, et
- un jeu de deux poutres 22a et 22b aptes à maintenir le support 6 suspendu au-dessus du substrat 4.

Ici, le cadre 18 est suspendu au-dessus d'un fond 24 (figure 1) d'une cavité 26 creusée dans une face supérieure du substrat 4. Cette cavité 26 est aussi délimitée par des parois verticales 28. A titre d'illustration seulement, la section horizontale de cette cavité 26 est rectangulaire ou carrée.

La section transversale du cadre 18 est, par exemple, également rectangulaire ou carrée.

Le cadre 18 comporte un évidement central rectangulaire ou carré le traversant de part en part le long de l'axe 10. Le support 6 est reçu à l'intérieur de cet évidement central. Ici, la section horizontale du support 6 est également rectangulaire ou carrée.

Les extrémités des poutres 20a et 20b sont ancrées sans aucun degré de liberté, d'un côté, à la paroi 28 et, d'un côté opposé, au cadre 18. Ces poutres 20a et 20b sont disposées de façon diamétralement opposé de part et d'autre de l'axe 10. Ici, les poutres 20a et 20b relient mécaniquement des angles respectifs du cadre 18 et des parois verticales 28 de la cavité 26. Ces poutres 20a et 20b s'étendent le long de l'axe 12.

La longueur Lₑₓₜ le long de l'axe 12 et la largeur lₑₓₜ perpendiculairement à cet axe des poutres 20a et 20b sont choisies de manière à :
- permettre une déformation en flexion de la poutre parallèlement au plan horizontal pour autoriser ainsi la rotation du cadre 16 autour de l'axe 10, et
- permettre une déformation en torsion de la poutre autour de l'axe 12 pour autoriser ainsi la rotation du cadre 16 autour de l'axe 12.

Par exemple, à cet effet, la largeur lₑₓₜ est au moins dix ou vingt fois inférieure à la longueur Lₑₓₜ.

L'épaisseur eₑₓₜ des poutres 20a et 20b dans la direction verticale est suffisante pour maintenir le cadre 18, les poutres 22a et 22b, et le support 6 suspendus au-dessus du fond 24. Ici, l'épaisseur eₑₓₜ est égale à l'épaisseur du cadre 18 et du support 6. Par exemple, cette épaisseur eₑₓₜ est supérieure ou égale à 10 µm.

Les extrémités des poutres 22a et 22b sont ancrées sans aucun degré de liberté, d'un côté, au cadre 18 et, du côté opposé, au support 6. Ici, ces poutres 22a et 22b s'étendent essentiellement le long de l'axe 14. Plus précisément, les poutres 22a et 22b sont disposées de façon diamétralement opposé par rapport à l'axe 10. Ici, elles relient des angles respectifs du support 6 à des angles en vis-à-vis du cadre 18.

La longueur Lᵢₙₜ le long de l'axe 14 et la largeur lᵢₙₜ perpendiculairement à cet axe des poutres 22a et 22b sont choisies pour :
- permettre la déformation en flexion de la poutre parallèlement au plan horizontal et autoriser ainsi la rotation du support 6 par rapport au cadre 18 autour de l'axe 10, et
- permettre la déformation en torsion de la poutre autour de l'axe 14 pour autoriser ainsi la rotation du support 6 autour de l'axe 14.

L'épaisseur eᵢₙₜ des poutres 22a et 22b dans la direction Z est suffisante pour maintenir le support 6 suspendu au-dessus du fond 24.

Par exemple, les dimensions Lᵢₙₜ, lᵢₙₜ et eᵢₙₜ sont choisies comme les dimensions, respectivement, Lₑₓₜ, lₑₓₜ et eₑₓₜ.

Des transducteurs sont prévus pour mesurer une grandeur physique représentative du couple exercé sur le support 6, respectivement, autour des axes 10, 12 et 14. Ici, la grandeur physique mesurée est un déplacement angulaire. A cet effet, le capteur 2 comporte des transducteurs capacitifs 30 à 33 (figure 2) utilisés pour mesurer le déplacement angulaire θ_{z} du support 6 autour de l'axe 10 et des transducteurs capacitifs 36 et 38 utilisés pour mesurer les déplacements angulaires, respectivement, θ_{X} et θ_{Y} autour, respectivement, des axes 12 et 14.

Chaque transducteur 30 à 33 est formé :
- d'une électrode mobile 40 reliée mécaniquement sans aucun degré de liberté au support 6 par l'intermédiaire d'un bras rigide 42, et
- d'une électrode fixe 44 fixée sans aucun degré de liberté sur le substrat 4.

Ici, les électrodes 40 et 44 sont interdigitées pour accroître la sensibilité de la mesure.

La rotation du support 6 autour de l'axe 10 entraîne le déplacement de l'électrode 40, ce qui modifie la distance entre les électrodes 40 et 44 et donc la capacité du transducteur. On peut donc ainsi mesurer l'angle θ_{Z}.

Le transducteur 36 comprend deux électrodes 46 et 47 fixées sans aucun degré de liberté sur le fond 24 en dessous du support 6. Les électrodes 46 et 47 sont disposées de part et d'autre de l'axe 10 le long de l'axe 14. Ici, ces électrodes 46, 47 sont symétriques l'une de l'autre par rapport à un axe correspondant à la projection de l'axe 12 sur le fond 24. Ces électrodes 46, 47 sont représentées en pointillé sur la figure 2. Ainsi, si le support 6 tourne autour de l'axe 12, d'un côté de l'axe 12, le support se rapproche de l'une des électrodes 46 ou 47 et, de l'autre côté de l'axe 12, le support 6 s'éloigne de l'autre de ces électrodes 46, 47. Ceci modifie donc la capacité formée par les électrodes 46 et 47 avec le fond du support 6 et donc permet de mesurer l'angle θ_{X},

Le transducteur 38 est réalisé à l'aide de deux électrodes 50 et 51. Ces électrodes 50 et 51 sont par exemple disposées comme décrit pour le transducteur 36 mais en transposant cette description pour la mesure de la rotation autour de l'axe 14.

Une source 54 de champ magnétique est fixée sans aucun degré de liberté sur le support 6. Cette source 54 génère un champ magnétique présentant un moment magnétique. La direction 55 de ce moment magnétique est représentée par une flèche sur la figure 2.

Dans ce mode particulier de réalisation, cette source est un aimant permanent magnétostrictif dont l'aimantation rémanente globale est non nul. Dans la suite de cette description, cet aimant porte également la référence 54. Plus précisément, ici, ce sont les propriétés magnétostrictives inverses de cet aimant qui sont utilisées, c'est-à-dire la possibilité de modifier les propriétés magnétiques de l'aimant en appliquant des contraintes mécaniques sur celui-ci. La propriété magnétique de l'aimant qui est modifiée par l'application de contrainte est la direction 55 du moment magnétique.

Dans ce mode de réalisation, l'aimant permanent 54 est un empilement alternant une couche en matériau ferromagnétique et une couche en matériau anti-ferromagnétique directement déposée sur la couche en matériau ferromagnétique. Les couches anti-ferromagnétiques servent à piéger la direction du moment magnétique des couches ferromagnétiques. De préférence, l'empilement comprend plusieurs couches ferromagnétiques et plusieurs couches antiferromagnétiques. De tels empilements sont bien connus pour réaliser la couche piégée ou la couche de référence utilisée en spintronique, par exemple, pour la réalisation d'oscillateurs radiofréquences.

En absence de champ magnétique extérieur, cet empilement présente une direction privilégiée d'aimantation proche de la saturation également appelée « direction de piégeage ». Par exemple, cette direction est alignée, en absence de contrainte mécanique, sur l'axe 12.

Typiquement, la couche ferromagnétique est réalisée à l'aide :
- d'un alliage polycristallin contenant du fer ou du fer et du cobalt et avec éventuellement un ou plusieurs éléments de substitution tels que du gallium ou du terbium, ou
- d'une composition amorphe comportant du fer, ou du fer et du cobalt avec un ou plusieurs composants amorphisants tels que du bore, de l'azote ou du carbone et avec un ou plusieurs éléments de substitution tels que du Gallium ou du Terbium (Tb).

La couche anti-ferromagnétique peut-être réalisée dans un alliage de manganèse tel qu'un alliage PtMn, IrMn, FeMn ou NiMn.

Ici, la couche ferromagnétique est un alliage de CoFeB et la couche anti-ferromagnétique est un alliage PtMn.

Un tel empilement présente un coefficient λₛ de magnétostriction positif typiquement compris entre 50 et 120 ppm et un champ magnétique coercitif compris entre 1 et 20 Oe (un Oersted est environ égal à 79,57 A.m⁻¹)

Sous l'action d'une contrainte mécanique uniaxiale en tension appliquée sur l'aimant 54 perpendiculairement à sa direction privilégiée d'aimantation, la direction 55 de son moment magnétique tourne. Par exemple, pour faire tourner la direction du moment magnétique de l'aimant 54 de 90°, une contrainte mécanique supérieure à 100 Mpa et, de préférence, comprise entre 100 Mpa et 1 Gpa doit être appliquée. De plus, toutes les directions du moment magnétique de cet aimant 54 comprises entre 0° et 90° sont des directions stables, c'est-à-dire qu'elles peuvent être maintenues indéfiniment tant que la contrainte mécanique correspondante est appliquée.

Pour modifier la direction 55 du moment magnétique, le capteur 2 comporte un dispositif 56 (figure 1). Ici, ce dispositif 56 est un générateur d'une contrainte mécanique. Dans la suite de cette description, ce générateur porte la même référence numérique que le dispositif 56. De préférence, le générateur 56 génère uniquement une contrainte uniaxiale perpendiculairement à la direction privilégiée d'aimantation de l'aimant 54.

Enfin, le capteur 2 comporte une unité 58 de traitement apte à commander le générateur 56 et à traiter les mesures des transducteurs 30 à 33, 36 et 38.

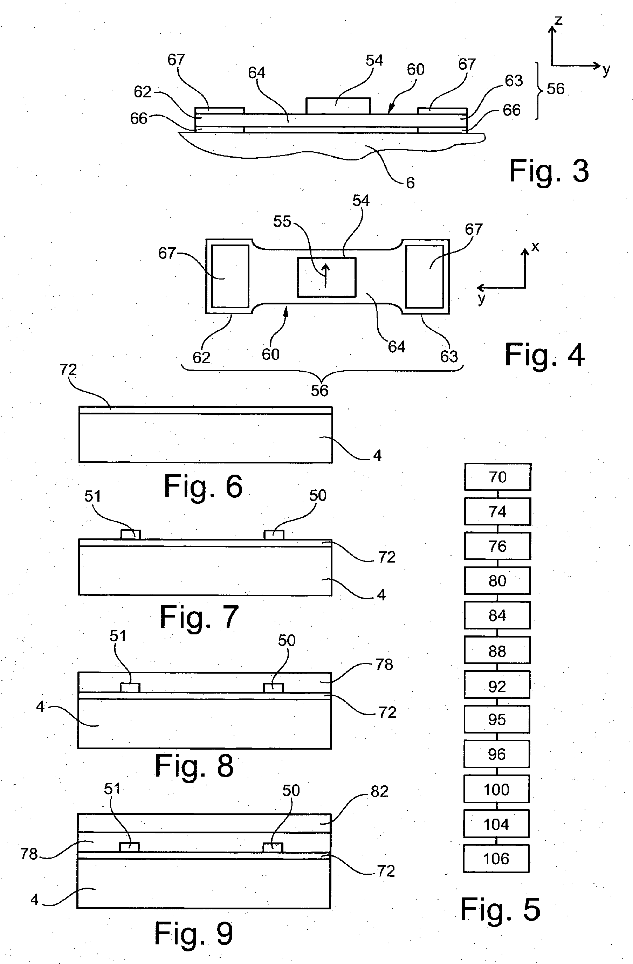

Les figures 3 et 4 représentent plus en détails le générateur 56. Ici, ce générateur 56 est identique à celui décrit dans la demande de brevet FR 2 905 793 publiée le 14 mars 2008. Ainsi, seule une description sommaire de ce générateur est faite ici. Pour plus de détails, le lecteur peut consulter la demande de brevet FR 2 905 793.

Le générateur 56 comporte une poutre 60 dont chaque extrémité 62, 63 est ancrée sans aucun degré de liberté sur une face supérieure du support 6. Entre ces extrémités 62, 63, la poutre 60 forme une branche centrale 64 suspendue au-dessus de la face supérieure du support 6.

Les extrémités 62, 63 et, de préférence, la branche centrale 64, sont réalisées dans un matériau piézoélectrique tel que du PZT (Titano-Zirconate de Plomb).

Pour actionner ce matériau piézoélectrique et générer une contrainte uniaxiale dans la direction longitudinale de la poutre, chaque extrémité 62 et 63 est interposée entre des électrodes inférieure 66 et supérieure 67 de commande.

L'aimant permanent 54 est fixé sans aucun degré de liberté, par exemple directement, sur la branche centrale 64 de sorte que sa direction privilégiée d'aimantation soit perpendiculaire à l'axe longitudinal de la poutre 60. Ici, l'axe longitudinal de la poutre 60 est parallèle à la direction Y.

La contrainte mécanique uniaxiale exercée sur l'aimant 54 croît typiquement de 1 MPa/V et, de préférence, d'au moins 10 MPa/V en fonction de la différence de potentiels entre les électrodes 66 et 67.

Le procédé de fabrication du capteur 2 va maintenant être décrit en référence au procédé de la figure 5 et à l'aide des figures 6 à 17.

Lors d'une étape 70, le substrat 4 est fourni et une couche 72 d'isolant électrique est déposée sur sa face supérieure (figure 6). Typiquement, le substrat 4 est un substrat en silicium.

Lors d'une étape 74, les électrodes 46, 47, 50 et 51 sont déposées et gravées à la surface de la couche 72 (figure 7). Sur la figure 7 et suivantes seules les électrodes 50 et 51 sont visibles.

Lors d'une étape 76, une couche sacrificielle 78 est déposée puis polie au-dessus des électrodes 46, 47, 50 et 51 (figure 8). Par exemple, la couche sacrificielle 78 est une couche en oxyde de silicium.

Lors d'une étape 80, une couche 82 de silicium est déposée sur la couche 78 par croissance épitaxiale (figure 9). Cette couche 82 de silicium présente typiquement une épaisseur verticale supérieure à 10 µm.

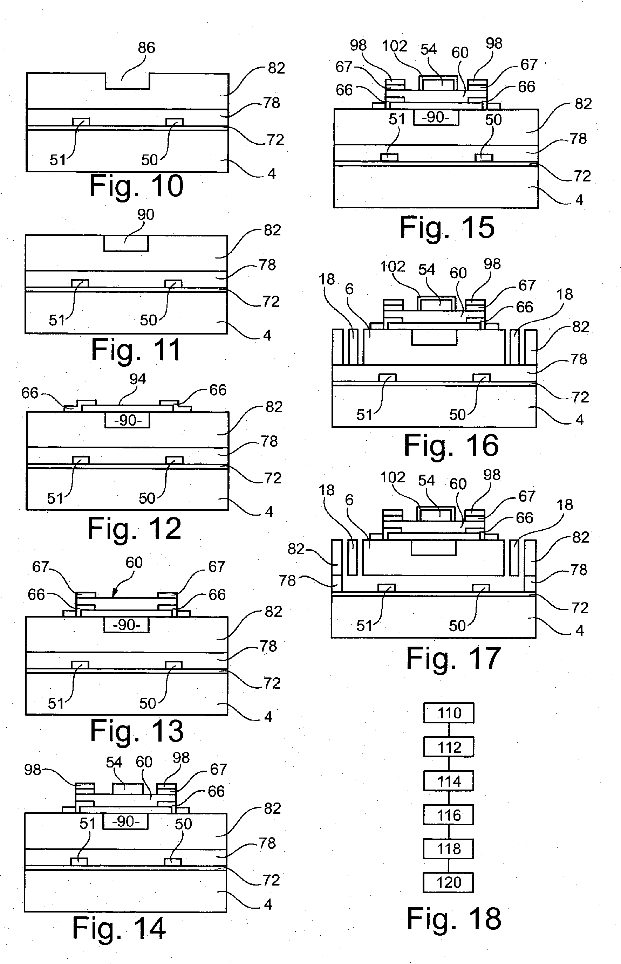

Lors d'une étape 84, une cavité 86 est creusée sensiblement au centre de la face supérieure de la couche 82 par photolithographie et gravure (figure 10). Cette cavité 86 est destinée à se retrouver sous la branche centrale 64 de la poutre 60.

Lors d'une étape 88, une couche sacrificielle 90 est déposée pour remplir la cavité 86 (figure 11). Cette couche 90 est ensuite polie pour rendre la face supérieure plane. Par exemple, la couche sacrificielle est en silicium polycristallin.

Lors d'une étape 92, une couche 94 d'isolant électrique est déposée sur la couche sacrificielle 90 (figure 12). Toujours lors de cette étape, les électrodes inférieures 66 du générateur 56 de contrainte sont déposées puis gravées sur la couche 94. Par exemple, ces électrodes sont en platine.

Lors d'une étape 95, la poutre 60 en matériau piézoélectrique est déposée et gravée sur la couche 94 (figure 13). Lors de cette étape, les électrodes supérieures 67 du générateur 56 sont également déposées et gravées.

Lors d'une étape 96, l'aimant permanent 54 est déposé puis gravé (figure 14). Lors de cette étape 96, des électrodes 98 en or sont également déposées et gravées sur les électrodes supérieures 67 pour permettre une prise de contact électrique sur ces électrodes supérieures.

Lors d'une étape 100, si cela est nécessaire, une couche de protection 102 est déposée puis gravée pour protéger l'aimant 54 lors des attaques subséquentes par gravure HF(acide fluorhydrique) vapeur (figure 15).

Lors d'une étape 104, le support 6, le cadre 18 et les poutres 20a, 20b, 22a et 22b sont formés dans la couche 82 par photolithographie puis gravure profonde DRIE (Deep Reactive Ion Etching) (figure 16).

Enfin, lors d'une étape 106, les couches sacrificielles 90 et la couche sacrificielle 78 située sous le support 6 sont éliminées (figure 17) pour libérer le mécanisme 16, le support 6 et la poutre 60. Typiquement, l'élimination de ces couches sacrificielles se fait par une étape de gravure vapeur HF.

Le fonctionnement du capteur 2 va maintenant être décrit en référence au procédé de la figure 18.

Initialement, lors d'une étape 110, le générateur 56 de contrainte n'applique aucune contrainte sur l'aimant 54. L'aimant 54 génère alors un champ magnétique dont la direction 55 du moment magnétique est alignée sur l'axe 12.

Lors d'une étape 112, les transducteurs 30 à 33 et 38 mesurent, respectivement, les angles θ_{Z} et θ_{Y} de rotation autour des axes, respectivement, 10 et 14. Ces angles θ_{Z} et θ_{Y} sont fonction du couple exercé par le champ magnétique à mesurer sur l'aimant 54.

Ensuite, lors d'une étape 114, l'unité de traitement 58 relève les signaux électriques générés par les transducteurs puis en déduit les mesures des angles θ_{Z} et θ_{Y}.

Ensuite, lors d'une étape 116, l'unité de traitement 58 commande le générateur 56 de manière à aligner la direction 55 du moment magnétique de l'aimant 54 sur l'axe 14.

Une étape 118 de mesure des angles θ_{Z} et θ_{X} à l'aide des transducteurs 30 à 33 et 36 est alors réalisée. Cette étape est similaire à l'étape 112 sauf que le transducteur 36 est utilisé à la place du transducteur 38.

Lors d'une étape 120, l'unité 58 de traitement relève les signaux électriques générés par les transducteurs lors de l'étape 118 et en déduit les mesures des angles θ_{Z} et θ_{X}. Ensuite, à partir des mesures de l'angle θ_{Z} relevées, respectivement, lors des étapes 112 et 118, l'unité 58 établit la valeur des composantes, respectivement, c_{Y} et c_{X}. L'unité 58 déduit également la valeur de la composante c_{Z} du champ magnétique à mesurer à partir des mesures des angles θ_{X} et θ_{Y} réalisées lors des étapes 112 et 118.

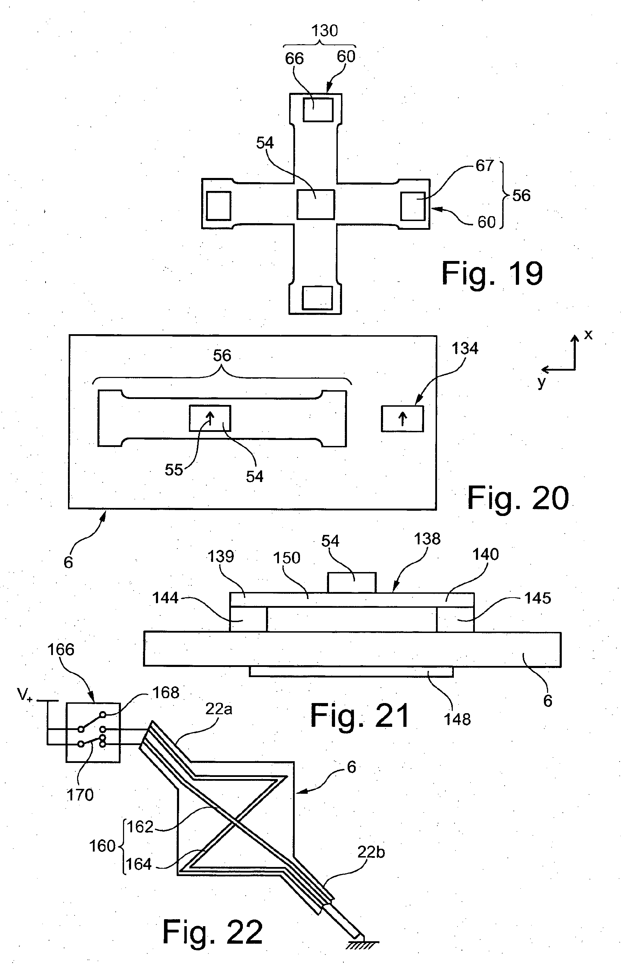

De nombreuses autres modes de réalisation du capteur 2 sont possibles. Par exemple, le dispositif de modification de la direction du moment magnétique de l'aimant 54 peut comporter plusieurs générateurs de contraintes mécaniques. La figure 19 représente un tel dispositif comportant le générateur 56 et un générateur supplémentaire 130 de contrainte magnétique. Le générateur 130 est conçu pour exercer une contrainte mécanique uniaxiale sur l'aimant 54 dans une direction différente de celle exercée par le générateur 56. Par exemple, le générateur 130 est identique au générateur 56 sauf qu'il est décalé angulairement par rapport à ce dernier, par exemple, de 90°. L'aimant 54 se trouve à l'intersection des poutres 60 des générateurs 56 et 130. Typiquement, cette intersection ne forme qu'un seul bloc de matière avec les poutres 60 des générateurs 56 et 130.

Ce dispositif est capable de générer une contrainte mécanique uniaxiale dans toutes les directions parallèles au plan du substrat 4 comprises dans un secteur angulaire de 0 à 90°. Cela peut s'avérer utile pour ajuster plus finement la direction 55 du moment magnétique.

La source de champ magnétique peut également comporter un aimant permanent dont la direction du moment magnétique ne peut pas être modifiée. Un tel mode de réalisation est illustré sur la figure 20. Par exemple, le support 6 de la figure 20 comprend l'aimant permanent 54, le générateur 56 de contrainte mécanique et un aimant permanent supplémentaire 134 directement déposé sur le substrat 6.

Sur la figure 20, en absence de contrainte mécanique, les moments magnétiques des aimants 54 et 134 sont parallèles à la direction X. Si le générateur 56 modifie la direction 55 du moment magnétique de l'aimant 54 pour l'aligner sur la direction Y, le moment magnétique de la source fait alors, par exemple, un angle de 45° avec la direction X. En effet, la direction du moment magnétique de la source de champ magnétique résulte dans ce cas de la combinaison des directions des moments magnétiques des aimants 54 et 134. A l'exception de cette différence, cette variante fonctionne comme précédemment décrit.

D'autres modes de réalisation du générateur de contrainte mécanique sont possibles. Par exemple, le générateur peut être actionné thermiquement et non pas à l'aide de matériau piézoélectrique. La figure 21 représente un tel mode de réalisation. Dans cette figure, l'aimant permanent 54 est déposé sur une poutre suspendue 138 dont la géométrie est, par exemple, identique à celle de la poutre 60. Des extrémités 139 et 140 de cette poutre sont fixées sans aucun degré de liberté à la face supérieure du support 6 par l'intermédiaire de cale rigide 144 et 145. La poutre 150 est réalisée dans un matériau ayant un coefficient de dilatation thermique identique ou différent du matériau utilisé pour réaliser le support 6.

Une source 148 de chaleur est prévue pour chauffer plus le substrat 6 que la poutre 138. Dans ces conditions, l'un de la poutre 138 et du substrat 6 se dilate plus que l'autre, ce qui entraîne l'apparition de contrainte mécanique uniaxiale dans l'aimant 54 fixé sur une branche centrale 150 de la poutre 138 suspendue au-dessus de la face supérieure du support 6.

La source de champ magnétique n'est pas nécessairement un aimant permanent. Par exemple, il peut aussi s'agir de fils conducteurs parcourus par un courant continu. La figure 22 représente une telle source 160 de champ magnétique. Ici, la source 160 comprend deux conducteurs électriques 162 et 164 fixés sans aucun degré de liberté sur la face supérieure du support 6. Dans ce mode de réalisation, l'aimant 54 et le générateur 56 de contrainte sont omis.

Le conducteur 162 s'étend parallèlement à l'axe 14. Le conducteur 164 s'étend dans une direction différente. Par exemple, le conducteur 164 dessine ici un Z sur la surface supérieure du support 6, la barre transversale de ce Z s'étendant sur la majorité de la diagonale du support 6 qui est parallèle à l'axe 12. De préférence, les barres horizontales de ce Z et, seulement ces barres horizontales, sont interposées entre des couches métalliques raccordées électriquement à la masse pour former un écran magnétique.

Les conducteurs 162 et 164 sont électriquement isolés les uns des autres de manière à pouvoir être alimentés en alternance. Ici, l'extrémité de chaque conducteur 162, 164 est raccordée à la masse et une autre extrémité opposée est raccordée à une source de tension continue V₊.

Le dispositif 56 est remplacé par un dispositif 166 apte à faire circuler, en alternance, un courant dans les conducteurs 162 et 164. A cet effet, le dispositif 166 comporte deux interrupteurs 168, 170 commandables. Pour modifier la direction du moment magnétique de la source 160, le dispositif 166 ouvre l'un des interrupteurs 168, 170 et ferme l'autre. Le reste du fonctionnement du capteur est identique à ce qui a été précédemment décrit.

Ainsi, dans ce mode de réalisation, la source de champ magnétique comprend un premier et un second conducteurs électriques isolés électriquement l'un de l'autre et fixés sans aucun degré de liberté sur le support mobile, ces conducteurs électriques s'étendant dans des directions respectives différentes parallèles au plan du substrat, et le dispositif commandable de modification de la direction du moment magnétique comporte des interrupteurs commandables pour alimenter, en alternance, les premier et second conducteurs électriques.

Le moment magnétique de la source de champ magnétique ne tourne pas nécessairement exactement de 90°. La direction du moment magnétique peut tourner d'une valeur angulaire différente de 90° mais ne doit pas tourner d'un multiple de 180°. En particulier, il n'est pas nécessaire que la direction du moment magnétique soit parallèle aux axes 12 et 14 de rotation du support 6. En effet, un simple calcul, tel qu'un changement de repère, permet d'établir les composantes c_{X} et c_{Y} du champ magnétique à mesurer avec un moment magnétique de la source qui n'est pas aligné ni sur l'axe 12 ni sur l'axe 14.

La direction du moment magnétique du champ magnétique généré n'est pas nécessairement parallèle au plan du substrat. En variante, cette direction comprend au moins une composante non nulle dans le plan du substrat et, éventuellement, aussi une composante non nulle dans la direction verticale.

La source de champ magnétique peut aussi être une couche mince en matériau magnétique doux anisotrope, c'est-à-dire présentant un moment magnétique mesurable uniquement lorsqu'elle est exposée à un champ magnétique extérieur. Typiquement, ces matériaux présentent un champ coercitif inférieure à 10 ou 70 A.m⁻¹. Ce matériau est par exemple un matériau ferromagnétique. Le matériau ferromagnétique est typiquement une composition amorphe contenant du fer ou du fer et du cobalt avec un ou plusieurs éléments amorphisants tels que le bore, l'azote ou le carbone et un ou plusieurs éléments de substitution tels que le Gallium et le Terbium. En réponse à une contrainte mécanique exercée en tension perpendiculairement à sa direction privilégiée d'aimantation, la direction du moment magnétique bascule de 90°. Contrairement à l'aimant permanent 54 décrit précédemment, une telle couche ferromagnétique ne présente que deux positions stables pour 0° et 90°. Il est possible de passer de l'une de ces positions stables à l'autre en appliquant une contrainte supérieure à 50 Mpa et, de préférence, une contrainte mécanique comprise entre 50 et 100 Mpa.

. L'aimant permanent peut également être réalisé en un seul bloc de matière de coefficient de magnétostriction suffisant, typiquement supérieur à 10⁻⁶ et avantageusement supérieur à 50.10⁻⁶ et non pas par un empilement de couches ferromagnétiques et anti-ferromagnétiques. La réalisation d'un tel aimant permanent dans des MEMS (Micro Electromechanical System) est par exemple décrite dans :
D.P. Arnold et Al., « Permanent Magnets for MEMS », Journal of Microelectromechanical systems, volume 18, n° 6, décembre 2009.

La source de champ magnétique peut aussi être un bloc de matériau magnétique doux isotrope. Par exemple, ce matériau ferromagnétique sera du Metglas® qui présente un coefficient λₛ de magnétostriction positif ou négatif selon sa composition.

La source de champ magnétique peut aussi être réalisée à l'aide d'un bloc de matériau magnétostrictif présentant un coefficient λₛ de magnétostriction négatif. Dans ce cas, sa direction privilégiée d'aimantation doit être parallèle à la direction de la contrainte mécanique en tension pour faire tourner la direction de son moment magnétique.

Le générateur de contrainte mécanique peut aussi être conçu pour exercer une contrainte mécanique uniaxiale en compression au lieu d'une contrainte mécanique uniaxiale en tension. Dans ce cas, les directions privilégiée d'aimantation précédemment décrites doivent être tournées de 90° parallèlement au plan du substrat.

Le générateur de contrainte mécanique peut aussi être réalisé différemment. Par exemple, il peut s'agir d'un générateur générant une contrainte mécanique à l'aide de déformation électrostatique.

Les transducteurs pour mesurer la rotation autour des axes 10, 12, et 14 peuvent être réalisés différemment. Par exemple, les transducteurs peuvent être remplacés par des transducteurs piézoélectriques. A cet effet, des poutres en matériau piézoélectrique s'étendant parallèlement aux poutres du mécanisme 16 sont prévues. Ces poutres sont, comme les poutres du mécanisme 16, ancrées par l'une de leurs extrémités au cadre et par l'autre au substrat pour mesurer la rotation du cadre autour de l'axe 10. Les poutres peuvent également être ancrées par l'une de leurs extrémités au cadre et par l'autre extrémité au support mobile 6 pour mesurer la rotation du support 6 autour de l'axe 10. Un exemple de telles poutres piézorésistives est par exemple décrit dans l'article suivant :
D. Ettelt et al, « *A new low consumption 3D compass using integrated magnets and piezoresistive nano-gauges* », Transducers 2011 Conference, Beijing, Chine.

En variante, un transducteur optique est utilisé pour mesurer la rotation du support 6.

En variante, les poutres 20a, 20b et 22a, 22b sont réalisées différemment. Par exemple, il n'est pas nécessaire que ces poutres relient les angles du cadre 18 aux angles de la cavité 26 ou les angles du support 6 aux angles de cadre 18. Les poutres peuvent être ancrées entre des faces verticales et parallèles du support 6, du cadre 18 et des parois 28.

D'autre géométrie du cadre 18 sont possibles. Par exemple, l'évidement central peut être circulaire.

En variante, les électrodes de commande de la poutre en matériau piézoélectrique sont placées différemment. Par exemple, elles peuvent être interdigitées et réparties sur toute la surface de la poutre.

Si on souhaite uniquement mesurer les composantes c_{X} et c_{Y} du champ magnétique dans le plan du substrat, le degré de liberté en rotation autour des axes horizontaux peut être omis. Par exemple, les poutres 20a, 20b et 22a, 22b sont alors conformées pour ne pas se déformer en torsion.

## Revendications

1. Capteur vectoriel de champ magnétique comportant :
- un substrat fixe (4) s'étendant essentiellement parallèlement à un plan dit « plan du substrat »,
- un support mobile (6) par rapport au substrat apte à se déplacer en rotation autour d'au moins un axe vertical Z (10) de rotation perpendiculaire au plan du substrat,
- une source (54 ; 134 ; 160) de champ magnétique présentant un moment magnétique dans une direction non perpendiculaire au plan du substrat, cette source étant fixée sans aucun degré de liberté sur le support mobile de manière à exercer un couple mécanique sur le support autour de l'axe vertical de rotation en présence d'un champ magnétique à mesurer non colinéaire à la direction de ce moment magnétique,
- au moins un transducteur (30-33, 36, 38) apte à convertir le couple exercé sur le support mobile autour de l'axe de rotation en un signal représentatif de l'amplitude d'une composante du champ magnétique à mesurer le long d'un axe de mesure contenu dans le plan du substrat,
**caractérisé en ce que** :
- la source de champ magnétique comporte un aimant permanent magnétostrictif (54 ; 134) dont la direction du moment magnétique varie en fonction de la contrainte mécanique exercée sur cet aimant, et
- le capteur comporte un dispositif commandable (56 ; 130 ; 138, 148) apte à modifier de façon réversible la direction du moment magnétique du champ magnétique généré par la source, ce dispositif commandable comportant un générateur (56 ; 130 ; 138, 148) de contrainte apte à faire varier la contrainte mécanique qui s'exerce sur l'aimant permanent pour faire varier la direction de son moment magnétique.

2. Capteur selon la revendication 1, dans lequel :
- le générateur (56 ; 130 ; 138, 148) de contrainte est apte à exercer une traction sur l'aimant permanent dans une direction d'étirement, et
- l'aimant permanent (54) présente un coefficient λₛ de magnétostriction positif et, en absence de contrainte mécanique sur cet aimant, la direction de son moment magnétique est perpendiculaire à la direction d'étirement à plus ou moins 10° près ou l'aimant permanent présente un coefficient λₛ de magnétostriction négatif et, en absence de contrainte mécanique, la direction de son moment magnétique est parallèle à la direction d'étirement à plus ou moins 10° près.

3. Capteur selon la revendication 1, dans lequel :
- le générateur (56 ; 130 ; 138, 148) de contrainte est apte à exercer une compression sur l'aimant permanent dans une direction de compression, et
- l'aimant permanent présente un coefficient λₛ de magnétostriction positif et, en absence de contrainte mécanique sur l'aimant permanent, la direction de son moment magnétique est parallèle à la direction de compression ou l'aimant permanent présente un coefficient λₛ de magnétostriction négatif et, en absence de contrainte mécanique, la direction de son moment magnétique est perpendiculaire à la direction de compression.

4. Capteur selon l'une quelconque des revendications précédentes, dans lequel :
- le générateur de contrainte comporte :
• une poutre (60) présentant une branche centrale suspendue au-dessus du substrat et dont les extrémités sont ancrées sans aucun degré de liberté au substrat, au moins l'une de ces extrémités étant réalisée dans un matériau piézoélectrique,
• des électrodes (66, 67) aptes à appliquer un champ électrique sur le matériau piézoélectrique pour générer une contrainte uniaxiale dans la branche centrale de la poutre, et
- l'aimant permanent (54) est fixé sans aucun degré de liberté sur la branche centrale de la poutre.

5. Capteur selon l'une quelconque des revendications précédentes, dans lequel :
- le générateur de contrainte mécanique comporte :
• une poutre (138) présentant une branche centrale suspendue au-dessus du substrat et dont les extrémités sont ancrées sans aucun degré de liberté au substrat, et
• un élément chauffant (148) apte à créer une différence de dilatation entre la poutre et le substrat, et
- l'aimant permanent (54) est fixé sans aucun degré de liberté sur la branche centrale de la poutre.

6. Capteur selon l'une quelconque des revendications précédentes, dans lequel le capteur comprend un mécanisme articulé (16) comportant :
- un cadre mobile (18) déplaçable en rotation autour d'un axe X de rotation parallèle au plan du substrat,
- un premier jeu de poutres (20a, 20b) raccordées mécaniquement, à une extrémité, au substrat (4) et, à leurs extrémités opposées, au cadre pour suspendre le cadre au-dessus du substrat, ces poutres s'étendant parallèlement à l'axe X et étant déformables élastiquement en flexion et en torsion de manière à permettre un déplacement en rotation du cadre autour des axes X et Z,
- un second jeu de poutres (22a, 22b) raccordées mécaniquement, à une extrémité, au support mobile et, à leurs extrémités opposées, au cadre pour suspendre le support mobile au-dessus du substrat, ces poutres s'étendant parallèlement à un axe Y perpendiculaire aux axes X et Z et étant déformables élastiquement en flexion et en torsion de manière à permettre un déplacement en rotation du support autour des axes Y et Z.

7. Capteur selon la revendication 6, dans lequel le dispositif (56 ; 166) est apte à faire basculer de façon réversible, la direction du moment magnétique du champ magnétique généré entre une position dans laquelle la direction du moment magnétique est parallèle à l'axe X et une position dans laquelle la direction du moment magnétique est parallèle à l'axe Y.

8. Procédé de mesure d'un champ magnétique à l'aide d'un capteur conforme à l'une quelconque des revendications précédentes, **caractérisé en ce que** ce procédé comporte :
a) la génération (110), par la source de champ magnétique, d'un champ magnétique présentant un premier moment magnétique dans une première direction non perpendiculaire au plan du substrat, puis
b) la mesure (112) d'une grandeur physique représentative du couple exercé sur le support mobile autour de l'axe Z lorsque le moment magnétique du champ magnétique généré par la source est dans la première direction, puis
c) la commande (116) du dispositif pour aligner la direction du moment magnétique du champ magnétique généré par la source dans une seconde direction non perpendiculaire au plan du substrat et différente de la première direction, puis
d) la mesure (118) d'une grandeur physique représentative du couple exercé sur le support mobile autour de l'axe vertical lorsque le moment magnétique du champ magnétique généré par la source est dans la seconde direction, et
e) l'établissement (120) de la valeur de deux composantes du champ magnétique mesuré, contenues dans le plan du substrat, à partir des grandeurs physiques mesurées lors des étapes b) et d).

## Patentansprüche

1. Vektorsensor eines Magnetfelds, welcher umfasst:
- ein festes Substrat (4), das sich im Wesentlichen parallel zu einer Ebene erstreckt, die als "Substratebene" bezeichnet ist,
- einen bezüglich des Substrats mobilen Träger, (6), der sich in Drehung um wenigstens eine zur Substratebene senkrechte vertikale Drehachse Z (10) rotativ verlagern kann,
- eine Magnetfeldquelle (54; 134; 160), die ein Magnetmoment in einer Richtung aufweist, welche nicht senkrecht zur Substratebene ist, wobei diese Quelle ohne Freiheitsgrad an dem beweglichen Träger derart befestigt ist, dass sie um die vertikale Drehachse herum ein mechanisches Moment auf den Träger ausübt, in Anwesenheit eines zu messenden Magnetfelds, das nicht kollinear zur Richtung dieses Magnetmoments ist,
- wenigstens einen Wandler (30-33, 36, 38), der in der Lage ist, das auf den beweglichen Träger um die Drehachse herum ausgeübte Moment in ein Signal umzuwandeln, das für die Amplitude einer Komponente des zu messenden Magnetfelds repräsentativ ist, entlang einer in der Substratebene enthaltenen Messachse, **dadurch gekennzeichnet, dass**:
- die Magnetfeldquelle einen magnetostriktiven Permanentmagneten (54; 134) umfasst, dessen Magnetmomentrichtung sich abhängig von der auf diesen Magneten ausgeübten mechanischen Belastung verändert, und
- der Sensor eine Bedienvorrichtung (56; 130 ;138, 148) umfasst, die die Richtung des Magnetmoments des durch die Quelle erzeugten Magnetfelds reversibel verändern kann, wobei die Bedienvorrichtung einen Erzeuger (56 ; 130 ; 138, 148) einer Belastung umfasst, der die auf den Permanentmagneten ausgeübte mechanische Belastung verändern kann, um die Richtung seines Magnetmoments zu verändern.

2. Sensor nach Anspruch 1, wobei:
- der Erzeuger (56; 130 ;138, 148) der Belastung in einer Zugrichtung einen Zug auf den Permanentmagneten ausüben kann, und
- der Permanentmagnet (54) einen Koeffizienten λ_{S} mit positiver Magnetostriktion aufweist, und in Abwesenheit einer mechanischen Belastung auf diesen Magneten die Richtung seines Magnetmoments bis auf ungefähr 10° senkrecht zur Zugrichtung ist, oder der Permanentmagnet einen Koeffizienten λ_{S} mit negativer Magnetostriktion aufweist, und in Abwesenheit einer mechanischen Belastung die Richtung seines Magnetmoments bis auf ungefähr 10° parallel zur Zugrichtung ist.

3. Sensor nach Anspruch 1, wobei:
- der Erzeuger (56; 130; 138, 148) der Belastung in einer Kompressionsrichtung eine Kompression auf den Permanentmagneten ausüben kann, und
- der Permanentmagnet einen Koeffizienten λ_{S} mit positiver Magnetostriktion aufweist, und in Abwesenheit einer mechanischen Belastung auf den Permanentmagneten die Richtung seines Magnetmoments parallel zur Kompressionsrichtung ist, oder der Permanentmagnet einen Koeffizienten λ_{S} mit negativer Magnetostriktion aufweist, und in Abwesenheit einer mechanischen Belastung die Richtung seines Magnetmoments senkrecht zur Kompressionsrichtung ist.

4. Sensor nach einem der vorangehenden Ansprüche, wobei:
- der Erzeuger der Belastung umfasst:
• einen Träger (60), der einen zentralen Arm aufweist, welcher über dem Substrat aufgehängt ist und dessen Enden ohne Freiheitsgrad am Substrat verankert sind, wobei wenigstens eines dieser Enden aus einem piezoelektrischen Material gebildet ist,
• Elektroden (66, 67), die ein elektrisches Feld an dem piezoelektrischen Material anlegen können, um in dem zentralen Arm des Trägers eine einachsige Belastung zu erzeugen, und
- der Permanentmagnet (54) ohne Freiheitsgrad auf dem zentralen Arm des Trägers befestigt ist.

5. Sensor nach einem der vorangehenden Ansprüche, wobei:
- der Erzeuger der mechanischen Belastung umfasst :
• einen Träger (138), der einen zentralen Arm aufweist, welcher über dem Substrat aufgehängt ist und dessen Enden ohne Freiheitsgrad am Substrat verankert sind, und
• ein Heizelement (148), das eine Ausdehnungsdifferenz zwischen dem Träger und dem Substrat bilden kann, und
- der Permanentmagnet (54) ohne Freiheitsgrad auf dem zentralen Arm des Trägers befestigt ist.

6. Sensor nach einem der vorangehenden Ansprüche, wobei der Sensor einen Gelenkmechanismus (16) aufweist, umfassend:
- einen beweglichen Rahmen (18), der drehbar um eine Drehachse X parallel zur Substratebene verlagerbar ist,
- einen ersten Satz Träger (20a, 20b), die mechanisch befestigt sind, an einem Ende am Substrat (4) und an ihren gegenüber liegenden Enden am Rahmen, um den Rahmen über dem Substrat aufzuhängen, wobei sich diese Träger parallel zur X-Achse erstrecken und zur Biegung und Torsion elastisch verformbar sind, um eine Drehverlagerung des Rahmens um die X- und Z-Achse zu ermöglichen,
- einen zweiten Satz Träger (22a, 22b), die mechanisch befestigt sind, an einem Ende am beweglichen Träger und an ihren gegenüber liegenden Enden am Rahmen, um den beweglichen Träger über dem Substrat aufzuhängen, wobei sich diese Träger parallel zu einer Y-Achse senkrecht zur X- und Z-Achse erstrecken und zur Biegung und Torsion elastisch verformbar sind, um eine Drehverlagerung des Trägers um die X- und Z-Achse zu ermöglichen.

7. Sensor nach Anspruch 6, wobei die Vorrichtung (56; 166) in der Lage ist, die Richtung des Magnetmoments des erzeugten Magnetfelds auf reversible Weise zwischen einer Position, in der die Richtung des Magnetmoments zur X-Achse parallel ist und einer Position, in der die Richtung des Magnetmoments zur Y-Achse parallel ist, zu kippen.

8. Verfahren zum Messen eines Magnetfelds mit Hilfe eines Sensors nach einem der vorangehenden Ansprüche, **dadurch gekennzeichnet, dass** das Verfahren umfasst:
a) Erzeugung (110) eines Magnetfelds mittels der Magnetfeldquelle, welches ein erstes Magnetmoment in einer ersten, zur Substratebene nicht senkrechten Richtung aufweist, dann
b) Messung (112) einer physikalischen Größe, die für das auf den beweglichen Träger um die Z-Achse ausgeübte Moment repräsentativ ist, wenn das Magnetmoment des durch die Quelle erzeugten Magnetfelds in der ersten Richtung liegt, dann
c) Steuerung (116) der Vorrichtung zum Ausrichten der Richtung des Magnetmoments des durch die Quelle erzeugten Magnetfelds in einer zweiten, zur Substratebene nicht senkrechten und von der ersten Richtung verschiedenen Richtung, dann
d) Messung (118) einer physikalischen Größe, die für das auf den beweglichen Träger um die vertikale Achse ausgeübte Moment repräsentativ ist, wenn das Magnetmoment des durch die Quelle erzeugten Magnetfelds in der zweiten Richtung liegt, und
e) Festsetzen (120) des Wertes zweier Komponenten des gemessenen Magnetfelds in der Substratebene auf der Grundlage der in den Schritten b) und d) gemessenen physikalischen Größen.

## Claims

1. A magnetic field vector sensor comprising:
- a fixed substrate (4) extending essentially parallel to a plane named "the substrate plane";
- a support (6) mobile relative to the substrate that can be moved in rotation around at least one vertical rotation axis Z (10) perpendicular to the substrate plane;
- a magnetic field source (54; 134; 160) generating a magnetic moment in a direction that is not perpendicular to said substrate plane, said source being fixed to the mobile support with no degree of freedom so as to exert a mechanical torque on the support around the vertical rotation axis in the presence of a magnetic field to be measured that is non-collinear to the direction of that magnetic moment;
- at least one transducer (30-33, 36, 38) suitable to convert the torque exerted on the mobile support around the rotation axis into a signal representative of the amplitude of a component of the magnetic field to be measured along a measurement axis contained in the substrate plane, **characterised in that**:
- the magnetic field source comprises a magnetostrictive permanent magnet (54; 134) the direction of whose magnetic moment varies according to the mechanical stress exerted on that magnet; and
- the sensor includes a controllable device (56; 130; 138; 148) suited to reversibly modifying the direction of the magnetic moment of the magnetic field generated by the source, said controllable device including a stress generator (56; 130; 138; 25; 148) suited to varying the mechanical stress exerted on the permanent magnet in order to vary the direction of its magnetic moment.

2. A sensor according to claim 1, in which:
- the stress generator (56; 130; 138; 148) is capable of exerting traction on the permanent magnet in a stretching direction; and
- the permanent magnet (54) has a positive magnetostriction coefficient λₛ and, in the absence of mechanical stress on this magnet, the direction of its magnetic moment is perpendicular to the stretching direction to within plus or minus 10° or the permanent magnet has a negative magnetostriction coefficient λₛ and, in the absence of mechanical stress, the direction of its magnetic moment is parallel to the stretching direction to within plus or minus 10°.

3. A sensor according to claim 1, in which:
- the stress generator (56; 130; 138;148) is capable of exerting compression on the permanent magnet in a compression direction; and
- the permanent magnet has a positive magnetostriction coefficient λₛ and, in the absence of mechanical stress on the permanent magnet, the direction of its magnetic moment is parallel to the compression direction or the permanent magnet has a negative magnetostriction coefficient λₛ and, in the absence of mechanical stress, the direction of its magnetic moment is perpendicular to the compression direction.

4. A sensor according to any of the previous claims, in which:
- the stress generator includes:
- a beam (60) having a central branch suspended above the substrate whose ends are anchored to the substrate with no degree of freedom, at least one of said ends being made from a piezoelectric material;
- electrodes (66, 67) capable of applying an electric field to the piezoelectric material in order to generate a uniaxial stress in the central branch of the beam; and
- the permanent magnet (54) is fixed with no degree of freedom to the central branch of the beam.

5. A sensor according to any of the previous claims, in which:
- the mechanical stress generator includes:
- a beam (138) having a central branch suspended above the substrate whose ends are anchored to the substrate with no degree of freedom; and
- a heating element (148) capable of creating an expansion difference between the beam and the substrate; and
- the permanent magnet (54) is fixed with no degree of freedom to the central branch of the beam.

6. A sensor according to any of the previous claims, in which the sensor includes an articulated mechanism (16) including:
- a mobile frame (18) displaceable in rotation around a rotation axis X parallel to the plane of the substrate;
- a first set of beams (20a, 20b) connected mechanically at one end to the substrate (4) and, at their opposite ends, to the frame in order to suspend the frame above the substrate, said beams extending parallel to the axis X and being elastically deformable in flexing and in torsion in such a way as to allow the frame to be displaced in rotation around the axes X and Z;
- a second set of beams (22a, 22b) connected mechanically at one end to the mobile support and, at their opposite ends, to the frame in order to suspend the mobile support above the substrate, said beams extending parallel to the axis Y perpendicular to the axes X and Z and being elastically deformable in flexing and in torsion in such a way as to allow the support to be displaced in rotation around the axes Y and Z.

7. A sensor according to claim 6, in which the device (56; 166) is capable of making the direction of the magnetic moment of the magnetic field generated turn reversibly between a position in which the direction of the magnetic moment is parallel to the axis X and a position in which the direction of the magnetic moment is parallel to the axis Y.

8. A method of measuring a magnetic field using a sensor according to any one of the previous claims, **characterised in that** this method includes:
a) the generation (110), by the magnetic field source, of a magnetic field having a first magnetic moment in a first direction that is not perpendicular to the plane of the substrate; then
b) the measurement (112) of a physical quantity representative of the torque exerted on the mobile support around the axis Z when the magnetic moment of the magnetic field generated by the source is in the first direction; then
c) the control (116) of the device in order to align the direction of the magnetic moment of the magnetic field generated by the source in a second direction not perpendicular to the plane of the substrate and different from the first direction; then
d) the measurement (118) of a physical quantity representative of the torque exerted on the mobile support around the vertical axis when the magnetic moment of the magnetic field generated by the source is in the second direction; and
e) the calculation (120) of the value of two components of the magnetic field measured, contained in the plane of the substrate, from the physical quantities measured during phases b) and d).
